Europäisches Patentamt

European Patent Office

Office européen des brevets

(19)

(11) Numéro de publication: **0 289 370 B1**

## (12) FASCICULE DE BREVET EUROPEEN

(45) Date de publication de fascicule du brevet: **29.07.92**  (51) Int. Cl.⁵: **G01R 19/165**

(21) Numéro de dépôt: **88400663.6**

(22) Date de dépôt: **18.03.88**

(54) **Dispositif de détection du niveau haut d'une tension en technologie MOS.**

(30) Priorité: **03.04.87 FR 8704721**

(43) Date de publication de la demande:
**02.11.88 Bulletin 88/44**

(45) Mention de la délivrance du brevet:
**29.07.92 Bulletin 92/31**

(84) Etats contractants désignés:
**DE FR GB IT NL**

(56) Documents cités:
**EP-A- 0 102 618**
**DE-A- 2 930 424**
**FR-A- 2 254 792**
**GB-A- 2 128 831**

(73) Titulaire: **SGS-THOMSON MICROELECTRO-
NICS S.A.
7, Avenue Galliéni
F-94250 Gentilly(FR)**

(72) Inventeur: **Kowalski, Jacek
50, lot, Les Jardins de Seignières
F-13530 Trets(FR)**
Inventeur: **Chevallier, Christophe Jean François
42, rue Lemée
F-13530 Trets(FR)**

(74) Mandataire: **Ballot, Paul Denis Jacques et al
Cabinet Ballot-Schmit, 7, rue le Sueur
F-75116 Paris(FR)**

Rank Xerox (UK) Business Services

## Description

La présente invention concerne un dispositif de détection du niveau haut d'une tension en technologie MOS.

En effet, dans un circuit intégré réalisé en technologie MOS, il est en général très difficile de détecter avec précision le niveau haut d'une tension notamment de la tension d'alimentation. Ceci résulte du fait que les paramètres des transistors sont déterminés avec une précision de l'ordre de ± 20 %, ce qui rend très difficile la conception d'une tension de référence. Or, les sources de tension sont le plus souvent réalisées à l'aide de transistors MOS. D'autre part plus haute est cette tension, plus on aura de variations au niveau de la tension de référence. Ceci est particulièrement gênant dans le cas de circuits intégrés MOS telles que les mémoires EPROM, EEPROM ou similaires dans lesquelles on utilise une certaine tension $V_{pp}$ pour réaliser la programmation de la cellule et une autre tension, généralement la tension d'alimentation $V_{cc}$ pour réaliser la lecture de la cellule. Ces mémoires sont réalisées de telle sorte qu'il est possible de les programmer à partir d'une tension $V_{pp}$ de l'ordre de 10 volts. Cela pose un problème si la tension de lecture $V_{cc}$ peut atteindre cette valeur, car il est alors possible de changer l'état des cellules-mémoire. Il est donc nécessaire de limiter la tension de lecture, à savoir la tension d'alimentation, à une valeur précise inférieure dans le présent cas à 10 volts.

La présente invention a pour but de remédier à ces inconvénients en fournissant un dispositif de détection du niveau haut d'une tension en technologie MOS qui émet un signal lorsque le niveau haut de la tension dépasse un niveau prédéterminé, ce signal pouvant être utilisé pour bloquer un circuit tel que le circuit de lecture dans le cas des mémoires EPROM ou EEPROM.

En conséquence, la présente invention a pour objet un dispositif de détection selon la revendication 1.

On notera que le brevet FR-A-2 254 792 décrit un détecteur de seuil de tension d'alimentation dans lequel le seuil est la somme des tensions de seuil d'un transistor MOS de type N et d'un transistor de type P.

Selon un mode de réalisation de la présente invention, la source de tension est constituée par n transistors MOS de type P (n'étant supérieur ou égal à 1) réalisés chacun dans un caisson de type N connecté à la source du transistor correspondant et montés en série entre la tension $V_{cc}$ et le noeud de sortie A et par un transistor MOS de type N connecté entre le noeud de sortie A et la tension basse ou masse, les grilles des transistors de type P et de type N étant reliées directement au drain ou à la source du transistor correspondant. De même, le moyen pour délivrer en sortie un niveau logique qui bascule lorsque le niveau haut de la tension $V_{cc}$ dépasse un seuil prédéterminé est constitué par un premier transistor MOS de type N dont la grille est connectée à la source de tension, la source est connectée à la tension basse ou masse par l'intermédiaire d'un moyen remontant sa tension dès l'apparition d'un courant et le drain est connecté à la tension d'alimentation par l'intermédiaire d'un moyen formant interrupteur, la sortie étant réalisée sur le drain.

De préférence, le moyen pour remonter la tension de la source du transistor MOS de type N est constitué par un autre transistor MOS de type N dont la grille est reliée à la tension $V_{cc}$, la source à la tension basse et le drain à la source du premier transistor MOS de type N. Le moyen formant interrupteur est constitué par un transistor MOS de type P dont la source est connectée à la tension $V_{cc}$, la grille à la tension basse ou masse et le drain au drain du premier transistor. Dans ce cas, le transistor MOS de type P présente un rapport W/L très inférieur à 1 et le premier transistor MOS de type N présente un rapport W/L très supérieur à 1 pour permettre d'obtenir sur la sortie soit la tension $V_{cc}$ soit la tension basse $V_{ss}$ ou masse en fonction de la conduction ou de la non-conduction du premier transistor MOS de type N.

De préférence, la sortie du moyen pour délivrer en sortie un niveau logique qui bascule lorsque le niveau haut de la tension d'alimentation dépasse un seuil prédéterminé est connecté à un inverseur. Dans ce cas, le moyen formant interrupteur peut être constitué par un premier transistor MOS de type P dont la source est connectée à la tension $V_{cc}$, la grille à la sortie de l'inverseur et le drain en entrée de l'inverseur et par un deuxième transistor MOS de type P monté en parallèle avec le premier transistor MOS, et dont la grille est connectée à un signal permettant l'initialisation du dispositif. Le premier transistor MOS de type P sera conducteur ou bloqué en fonction du signal en sortie de l'inverseur ; le deuxième transistor MOS de type P servant à initialiser le circuit.

D'autres caractéristiques et avantages de la présente invention apparaîtront à la lecture de la description de différents modes de réalisation faite ci-après avec référence au dessin ci-annexé dans lequel :
- la figure 1 est un schéma électrique d'un premier mode de réalisation d'un circuit de détection conforme à la présente invention, et
- la figure 2 est un schéma électrique d'un deuxième mode de réalisation d'un circuit de détection conforme à la présente invention.

Pour simplifier la description dans les figures les mêmes éléments portent les mêmes références.

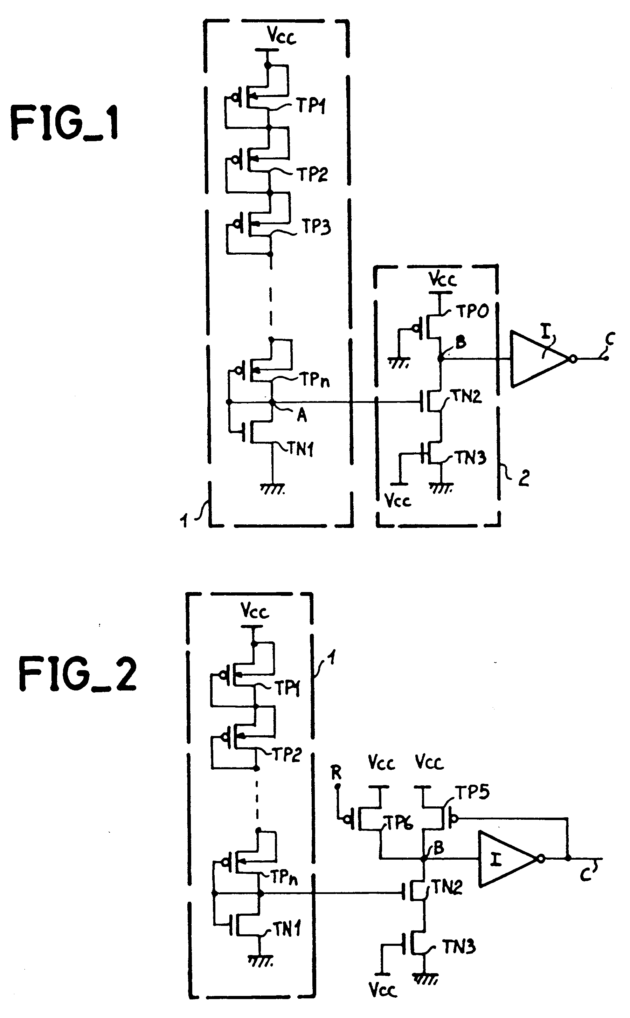

Comme représenté sur la figure 1, le circuit de détection du niveau haut d'une tension en technologie MOS conforme à la présente invention comporte essentiellement une source de tension 1, un moyen pour délivrer en sortie un niveau logique qui bascule lorsque le niveau haut de la tension $V_{cc}$ dépasse un seuil prédéterminé et éventuellement un inverseur 1. De manière plus spécifique, la source de tension 1 est constituée par n transistors MOS de type P TP1, TP2, TP3, ..... TPn montés en série et par un transistor MOS de type N TN1. Le nombre n de transistors de type P est choisi en fonction de la tension $V_{cc}$ dont on doit déterminer le niveau haut et en fonction de la tension de seuil des différents transistors.

De manière plus spécifique, le transistor de type P TP1 est connecté de telle sorte que sa source soit reliée à la tension $V_{cc}$ et son drain relié à la source du transistor P TP2 dont le drain est relié à la source du transistor de type P TP3 et ainsi de suite. Le drain du transistor de type P TPn est connecté au noeud A donnant la sortie de la source de tension. D'autre part, les grilles des transistors TP1 à TPn sont chacune reliées au drain du transistor correspondant. Conformément à la présente invention, chaque transistor TP1 à TPn est réalisé dans un caisson de type N indépendant et chaque caisson est connecté à la source du transistor de type P correspondant. De ce fait, la tension de seuil des transistors de type P est parfaitement déterminée, car l'effet substrat c'est-à-dire la variation de la tension de seuil en fonction de la tension source-substrat est éliminée. D'autre part, la source de tension comporte un transistor N TN1 dont la source est connectée à une tension basse $V_{ss}$ ou à la masse et dont le drain est connecté au noeud de sortie A. La grille du transistor TN1 est reliée à son drain. De préférence les transistors TP1 à TPn présentent une même tension de seuil.

Dans ce cas, la tension au noeud A sera située entre $V_{ss}$ et VTN si $V_{cc}$<n.VTP + VTN (transistors TN1 et TP1 sont bloqués) et sera égale à $V_{cc}$ - n.VTP si $V_{cc}$>n.VTP + VTN, VTP représentant la tension de seuil des transistors de type P et VTN celle du transistor de type N.

Cette source de tension 1 est connectée au moyen 2 qui comporte un premier transistor de type N TN2 dont la source est connectée à la tension basse ou masse par l'intermédiaire d'un deuxième transistor MOS de type N TN3 dont la grille est connectée à la tension $V_{cc}$, ce qui le rend toujours passant. D'autre part, le drain du transistor TN2 est connecté au drain d'un transistor P TP0 dont la source est connectée à la tension $V_{cc}$ et dont la grille est connectée à la tension basse ou masse. La sortie du moyen 2 est réalisée au noeud B entre les transistors TP0 et TN2. De préférence, comme représenté sur la figure 1, le noeud B est relié à un inverseur 1 et le signal de sortie du dispositif est obtenu sur la sortie C de l'inverseur. On expliquera maintenant le fonctionnement du circuit représenté à la figure 1.

Avec le circuit représenté à la figure 1, il est possible de détecter une tension $V_{cc}$ égale à n.VTP + VTN. Si la tension $V_{cc}$ est inférieure à nVTP + VTN, il n'y a aucun courant continu dans aucune des branches. La tension au noeud A est inférieure à VTN, c'est-à-dire inférieure à la tension de seuil du transistor de type N TN1. De ce fait, le transistor TN2 est bloqué. D'autre part, le noeud B est positionné à $V_{cc}$. En effet le transistor TP0 dont la grille est connectée à la masse est conducteur et applique au point B la tension $V_{cc}$. Comme le transistor TN3 dont la grille reçoit la tension $V_{cc}$, est lui aussi conducteur, il empêche la conduction du transistor TN2 en remontant sa tension de source dès l'apparition d'un courant.

Si la tension $V_{cc}$ dépasse nVTP + VTN, la tension au noeud A remonte et suit la montée de $V_{cc}$. Le transistor TN2 se débloque alors et force le noeud B à $V_{ss}$. En effet, le transistor TN2 a été conçu de telle sorte que son rapport W/L soit très supérieur à 1 tandis que le rapport W/L du transistor TP0 est très inférieur à 1, ce qui permet de forcer la tension au noeud B lorsque le transistor TN2 conduit. A titre d'exemple, en technologie C-MOS, 2 microns, le transistor MOS de type P TP0 présente un rapport W/L = 2/25 tandis que le transistor MOS de type N TN2 présente un rapport W/L = 10/2. Le noeud B étant à $V_{ss}$, c'est-à-dire au niveau logique "0", on obtient en sortie de l'inverseur I un niveau logique "1", c'est-à-dire un signal de détection qui peut être utilisé pour bloquer un circuit.

Pour bloquer le transistor P TP0 dès la détection d'une tension $V_{cc}$ supérieure à n VTP + VTN, on peut utiliser le circuit représenté à la figure 2. Dans ce cas, l'inverseur 1 fait partie intégrante du circuit de détection du niveau haut et la grille du transistor P TP5 utilisée à la place du transistor TP0 est reliée à la sortie C de l'inverseur I au lieu d'être connectée à la tension basse ou masse. Toutefois, pour initialiser le système on utilise un transistor P TP6 dont la source est connectée à la tension $V_{cc}$ et le drain au noeud B, la grille du transistor TP6 étant reliée à un signal R de remise à zéro. Ce transistor TP6 permet de positionner le noeud B à la tension $V_{cc}$ au début de fonctionnement du circuit de détection. Ensuite, dès que le noeud passe à $V_{ss}$ le niveau sur la sortie C de l'inverseur passe au niveau 1 ce qui bloque le transistor TP5 et maintient le noeud a à $V_{ss}$.

Le circuit décrit ci-dessus avec référence aux figures 1 et 2 présente de nombreux avantages :

- la tension de détection est telle que Y = (n VTP + VTN) ± 10%. En effet, les tensions de seuil des transistors P ou des transistors N sont en général contrôlées avec de très bonnes précisions surtout dans le cas des procédés de fabrication bien stabilisées.
- la consommation statique du circuit est nulle jusqu'au moment où l'on détecte que la tension $V_{cc}$ dépasse le seuil prédéterminé. En fonctionnement normal, le circuit ci-dessus n'est pas utilisé. Dans des applications monétiques, il peut être utilisé comme dispositif de sécurité.

**Revendications**

1. Dispositif de détection du niveau haut d'une tension d'alimentation Vcc en technologie MOS, comprenant, entre une borne d'alimentation recevant cette tension et une borne de masse, un ensemble en série d'un transistor MOS de conductivité N (TN1) et d'une source de tension de référence, caractérisé en ce que la source de tension de référence est constituée par plusieurs transistors MOS de conductivité P (TP1 à TPn) réalisés chacun dans un caisson de type N séparé des autres, le caisson étant relié à la source du transistor correspondant, la grille et le drain de chaque transistor étant reliés afin que le dispositif delivre en sortie un niveau logique qui bascule lorsque le niveau haut de la tension Vcc dépasse un seuil prédeterminé.

2. Dispositif selon la revendication 1, caractérisé en ce qu'il comporte un deuxième transistor MOS de conductivité N (TN2) dont la grille est reliée au point de jonction entre le premier transistor de type N et les transistors de type P, dont la source est reliée à la masse par l'intermédiaire d'un moyen (TN3) remontant sa tension dès l'apparition d'un courant, et dont le drain, constituant la sortie du dispositif, est relié à la borne d'alimentation par l'intermédiaire d'un interrupteur (TP0); TP5, TP6)

3. Dispositif selon la revendication 2, caractérisé en ce que le moyen pour remonter la tension de la source du deuxième transistor MOS de conductivité N (TN2) est constitué par un troisième transistor MOS du même type (TN3) dont la grille est reliée à la borne d'alimentation, la source à la masse, et le drain à la source du deuxième transistor de type N.

4. Dispositif selon la revendication 2, caractérisé en ce que l'interrupteur est constitué par un transistor MOS de conductivité P (TP0), dont la source est connectée à la borne d'alimentation, la grille à la masse, et le drain au drain du deuxième transistor de conductivité N.

5. Dispositif selon la revendication 4, caractérisé en ce que le transistor (TP0) constituant l'interrupteur présente un rapport largeur de canal sur longueur de canal W/L très inférieur à 1 et le deuxième transistor de type N présente un rapport largeur de canal sur longueur de canal W/L très supérieur à 1.

6. Dispositif selon la revendication 5, caractérisé en ce que pour le transistor constituant l'interrupteur le rapport largeur sur longeur W/L très inférieur à 1 est de 2/25 et que pour le deuxième transistor de type N le rapport W/L très supérieur à 1 est de 5.

7. Dispositf selon la revendication 2, caractérisé en ce que l'interrupteur est constitué par un premier transistor de conductivité P (TP5) dont la source est connectée à la borne d'alimentation, la grille à la sortie d'un inverseur dont l'entrée est connectée au drain du deuxième transistor de conductivité N (TN2), et le drain est connecté à l'entrée de l'inverseur, et par un deuxième transistor de conductivité P (TP6) monté en parallèle avec le premier et dont la grille peut recevoir un signal permettant l'initialisation du dispositif.

**Claims**

1. A device made using MOS technology for detecting a high level of a supply voltage $V_{cc}$ comprising, between a supply terminal receiving this voltage and a ground terminal, a series connected arrangement of an N type MOS transistor(TN1) and a reference voltage source, characterized in that the reference voltage source comprises a plurality of P type MOS transistors (TP1 to TPn) each formed in an N type island separated from the others, the island being connected to the source of the corresponding transistor, the gate and the drain of each transistor being connected so that the device supplies at its output a logic level which switches when the high level of the voltage $V_{cc}$ exceeds a predetermined threshold.

2. A device as claimed in claim 1, characterized in that it comprises a second N type MOS transistor (TN2) the gate of which is connected to the junction point between the first N type transistor and the P type transistors, the source of which is connected to ground through the intermediary of a means (TN3) for raising its voltage as soon as a current appears and the drain of which, forming the output of the device, is connected to the supply terminal through the intermediary of a switch (TP0; TP5, TP6).

3. A device as claimed in claim 2, characterized in that the means for raising the voltage at the source of the second MOS transistor of N type conductivity (TN2) is constituted by a third MOS transistor of the same type (TN3) of which the gate is connected to the supply terminal, the source to ground, and the drain to the source of the second N type transistor.

4. A device as claimed in claim 2, characterized in that the switch is constituted by a P type MOS transistor (TP0) of which the source is connected to the supply terminal, the gate to ground, and the drain to the drain of the second N type transistor.

5. A device as claimed in claim 4, characterized in that the transistor (TP0) constituting the switch has a channel width to channel length ratio W/L much less than 1 and the second N type transistor has a channel width to channel length ratio W/L much greater than 1.

6. A device as claimed in claim 5, characterized in that in the case of the transistor constituting the switch the width to length ratio W/L much smaller than 1 is 2/25 and in the case of the second N type transistor the ratio W/L much greater than 1 is 5.

7. A device as claimed in claim 2, characterized in that the switch is constituted by a first P type conductivity transistor (TP5), the source of which is connected to the supply terminal, the gate being connected to the output of an inverter the input of which is connected to the drain of the second N type transistor (TN2), and the drain being connected to the input of the inverter, and by a second P type conductivity transistor (TP6) which is mounted in parallel to the first and the gate of which can receive a signal allowing the initialization of the device.

**Patentansprüche**

1. Vorrichtung zur Erfassung des hohen Pegels einer Versorgungsspannung Vcc in der MOS-Technologie, umfassend zwischen einem Versorgungsanschluß, der diese Spannung aufnimmt, und einem Masseanschluß eine Reihenanordnung eines MOS-Transistors mit N-Leitfähigkeit (TN1) und einer Bezugsspannungsquelle, dadurch **gekennzeichnet,** daß die Bezugsspannungsquelle aus mehreren MOS-Transistoren mit P-Leitfähigkeit (TP1 bis TPn) besteht, die jeweils in einer N-Typ-Zone getrennt von den anderen ausgeführt sind, wobei die Zone mit der Source des entsprechenden Transistors verbunden ist, wobei das Gate und der Drain jedes Transistors verbunden sind, damit die Vorrichtung am Ausgang einen logischen Pegel liefert, der kippt, wenn der hohe Pegel der Spannung Vcc einen vorbestimmten Schwellwert überschreitet.

2. Vorrichtung nach Anspruch 1, dadurch **gekennzeichnet,** daß sie einen zweiten MOS-Transistor mit N-Leitfähigkeit (TN2) umfaßt, dessen Gate mit der Verbindungsstelle zwischen dem ersten Transistor vom N-Typ und den Transistoren vom P-Typ verbunden ist, deren Source mit Masse mittels einer Einrichtung (TN3) verbunden ist, die ihre Spannung gleich mit Auftreten eines Stroms erhöht, und deren den Ausgang der Vorrichtung bildender Drain mittels eines Schalters (TP0; TP5, TP6) mit dem Versorgungsanschluß verbunden ist.

3. Vorrichtung nach Anspruch 2, dadurch **gekennzeichnet,** daß die Einrichtung zur Erhöhung der Source-Spannung des zweiten MOS-Transistors mit N-Leitfähigkeit (TN2) aus einem dritten MOS-Transistor vom selben Typ (TN3) besteht, dessen Gate mit dem Versorgungsanschluß, die Source mit Masse und der Drain mit der Source des zweiten Transistors vom N-Typ verbunden ist.

4. Vorrichtung nach Anspruch 2, dadurch **gekennzeichnet,** daß der Schalter aus einem MOS-Transistor mit P-Leitfähigkeit (TP0) besteht, dessen Source an den Versorgungsanschluß, das Gate an Masse und der Drain an den Drain des zweiten Transistors mit N-Leitfähigkeit angeschlossen ist.

5. Vorrichtung nach Anspruch 4, dadurch **gekennzeichnet,** daß der den Schalter bildende Transistor (TP0) ein Verhältnis Kanalbreite zu Kanallänge W/L viel kleiner als 1 aufweist und der zweite Transitor vom N-Typ ein Verhältnis Kanalbreite zu Kanallänge W/L viel größer als 1 aufweist.

6. Vorrichtung nach Anspruch 5, dadurch **gekennzeichnet,** daß für den den Schalter darstellenden Transistor das Verhältnis Breite zu Länge W/L mit 2/25 viel kleiner als 1 ist und daß für den zweiten Transistor vom N-Typ das Verhältnis W/L mit 5 viel größer als 1 ist.

7.  Vorrichtung nach Anspruch 2, dadurch **gekennzeichnet,** daß der Schalter aus einem ersten Transistor mit P-Leitfähigkeit (TP5), dessen Source an den Versorgungsanschluß angeschlossen ist, das Gate an den Ausgang eines Inverters angeschlossen ist, dessen Eingang an den Drain des zweiten Transistors mit N-Leitfähigkeit (TN2) angeschlossen ist, und der Drain an den Eingang des Inverters angeschlossen ist, und aus einem zweiten Transistor mit P-Leitfähigkeit (TP6) besteht, der parallel zu dem ersten geschaltet ist und dessen Gate ein die Initialisierung der Vorrichtung gestattendes Signal aufnehmen kann.

FIG_1

FIG_2